# EUROPEAN PATENT APPLICATION

(11) **EP 4 541 934 A2**
(43) Date of publication of application: **23.04.2025**
(21) Application number: 24206315.4
(22) Date of filing: 14.10.2024
(51) Int. Cl.: C23C 16/44, C23C 16/455, C23C 16/458, C30B 25/14, H01J 37/32, H01L 21/67

(54) **APPARATUS FOR MANUFACTURING SEMICONDUCTOR DEVICES**

(30) Priority: 17.10.2023 IT 202300021630
(71) Applicant: LPE S.p.A., 20021 Baranzate (MI) (IT)
(72) Inventor: PRETI, Silvio Roberto Mario, 20021 Baranzate (MI) (IT)
(74) Representative: Buzzi, Notaro & Antonielli d'Oulx S.p.A.

(57) **Abstract**

Apparatus for manufacturing semiconductor devices of the type comprising a substrate (101) and a film applied onto the substrate by means of a chemical-vapor-deposition (CVD) process, comprising:
- a chamber (2) containing a reaction and deposition zone (100) in which to arrange at least one substrate (101), and comprising at least a wall (2D, 2E; 220') delimiting the reaction and deposition zone (100);
- a first gas source (20) for supplying a flow of process gas into the reaction and deposition zone (100) in a first direction;
- a second gas source (40) for supplying an inert gas into the reaction and deposition zone (100) in a second direction.

The at least a wall (2D, 2E; 220') of the chamber (2) comprises a plurality of holes (28) on the reaction and deposition zone (100), which are in fluid communication with the second gas source (40) and are configured to introduce the inert gas into the reaction and deposition zone (100) to form a gas layer (200) separating at least a portion of the at least a wall (2D, 2E; 220') from a contact by the flow of process gas (F) .

## Description

### Technical field of the invention

The present invention relates to an apparatus for manufacturing semiconductor devices of the type comprising a substrate and a film applied onto the substrate by means of a chemical-vapor-deposition (CVD) process.

An apparatus of this type comprises a chamber containing a reaction and deposition zone in which to arrange at least one substrate and in which a process gas supplied to the process chamber undergoes a CVD process to form a film on the substrate.

One problem to be dealt with in apparatuses of this type is represented by the deposition on the walls of the chamber of particulates generated as a result of the reaction of the process gas.

These particles may then grow while attached to the wall of the chamber until they separate from it and possibly deposit on the substrate, thus affecting the quality of the film deposited on it. In order to avoid the risk of compromising the quality of the film deposited on the substrate, a common solution is to program interventions of maintenance at predetermined intervals to keep the accumulation of these particulates in the chamber below a predetermined level.

However, these stops reduce the productivity of the apparatus.

Therefore, it is felt the need to reduce the frequency of maintenance of the apparatus, while preserving the quality of the film realized on the substrate by CVD.

### Summary of the invention

The present invention proposes an apparatus for manufacturing semiconductor devices to solve the above- discussed technical problem.

The present invention relates in a general way to an apparatus according to Claim 1.

The present invention also relates to a method according to Claim 10.

The claims form an integral part of the teachings provided here.

### Brief description of the drawings and detailed description of one or more embodiments of the invention

Further characteristics and advantages of the invention will be apparent from the following description, which refers to the attached drawings provided purely by way of non-limiting example, in which:
- Figure 1 is a schematic view of a preferred embodiment of the apparatus described here, in which the process chamber of the apparatus is illustrated according to a cross-section view;
- Figure 2 is a cross-section view of the process chamber of Figure 1 taken along the plane II-II indicated in Figure 1;
- Figure 2A is a cross-section view of a process chamber of an alternative embodiment of the apparatus described here;
- Figure 3 is an enlarged view of a detail of figure 1;
- Figure 4 is a schematic view of a further embodiment of the apparatus described here, in which the process chamber of the apparatus is illustrated according to a cross-section view;
- Figure 5 is a schematic view of a second further embodiment of the apparatus described here, in which the process chamber of the apparatus is illustrated according to a cross-section view;
- Figure 6 illustrates a process chamber of a further embodiment of the apparatus described here;
- Figures 7A and 7B each illustrate a diagram representing the curves of operating parameters over time, during a process implemented in the apparatus described here.

The following description illustrates various specific details intended to provide a deeper understanding of the embodiments. The embodiments may be realized without one or more of the specific details, or with other methods, components or materials, etc. In other cases, known structures, materials or operations are not shown or described in detail, to avoid obscuring various aspects of the embodiment.

The references used here are purely for convenience and therefore do not define the scope of protection or the extent of the embodiments.

As mentioned above, the apparatus described here is an apparatus for manufacturing semiconductor devices of the type comprising a substrate and a film applied (e.g., deposited) onto the substrate by means of a chemical-vapor-deposition (CVD) process or a low pressure chemical vapor deposition (LPCVD) process. For instance, the deposited film may comprise or consist of silicon carbide. Preferably, the CVD process is an epitaxial CVD.

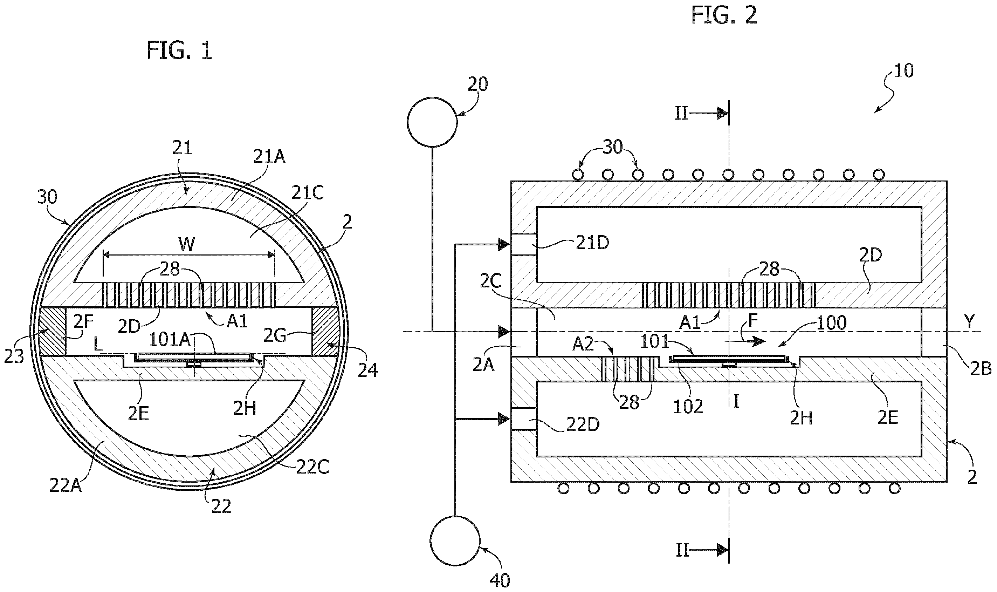

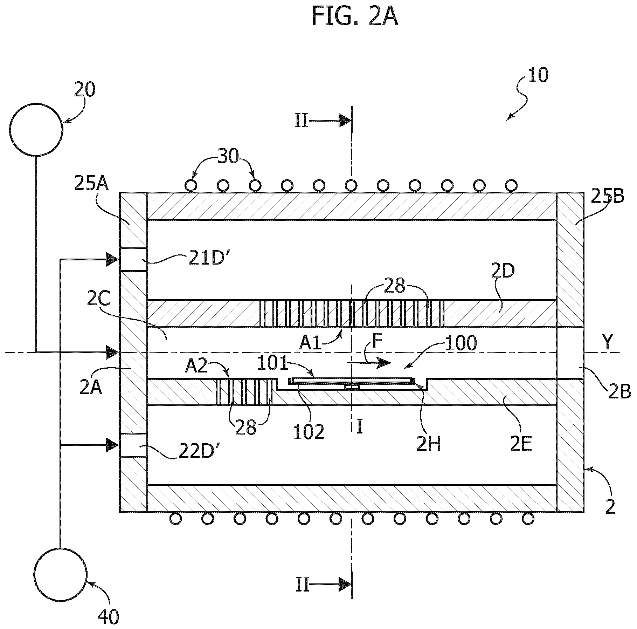

With reference to Figures 1 and 2, the apparatus
- which is indicated as a whole by the reference numeral 10 - comprises a chamber 2 containing a reaction and deposition zone 100 in which to arrange at least one substrate 101 that is to undergo the CVD process.

The apparatus also comprises a first gas source 20 for supplying a flow of process gas F into the reaction and deposition zone 100.

The process gas (F) may comprise a silicon precursor gas and a carbon precursor gas.

For example, the silicon precursor gas may be a chlorinated compound, preferably dichlorosilane, trichlorosilane or tetrachlorosilane.

The carbon precursor gas may be a hydrocarbon, in particular propane or ethylene or acetylene or methane. Other types of precursors may be used.

The process gas (F) may also comprise other precursors, such as sources for n- and p- doping. For instance, the n-source may be nitrogen, acetonitrile, pyrrole, ammonia, hydrazine, hydrogen cyanide, methylamine.

The chamber 2 has an inlet 2A, which receives the process gas from the first gas source 20, and an outlet 2B, through which a process exhaust gas exits the chamber 2.

The chamber 2 extends along a reference axis Y from the inlet 2A to the outlet 2B and defines an inner flow passage 2C setting in fluid communication the inlet 2A to the outlet 2B and containing the reaction and deposition zone 100.

In one or more preferred embodiments, such as the one illustrated, the inner flow passage 2C has a cross-section that is substantially constant and uniform all along the reference axis Y, i.e. from the inlet to the outlet and across the reaction and deposition zone 100.

In one or more preferred embodiments, such as the one illustrated (see Figure 2), the inner flow passage 2C has a rectangular or square cross section and is delimited by a plurality of walls of the chamber 2, namely an upper wall 2D, a lower wall 2E, a left-side wall 2F and a right-side wall 2G.

In one or more preferred embodiments, such as the one illustrated, in the lower wall 2E is provided a receiving area 2H configured to receive the substrate 101.

In one or more preferred embodiments, such as the one illustrated, the receiving area 2H may be provided with a supporting element 102 which is configured to receive the substrate 101 and, in operation, can rotate about a vertical axis of rotation I.

The substrate 101 received in the receiving area 2H, possibly supported by the supporting element 102, presents its upper surface 101A to lie in a given lying plane L.

In one or more preferred embodiments, such as the one illustrated, the lying plane L is above the lower wall 2E.

The chamber 2 is preferably made of a material that is both heat conductive and resistant to high temperatures; incidentally, it is noted that by "high temperatures" it is meant temperatures higher than 1000°C and up to 1700°C, which represents the range of temperatures normally required in a process chamber during a CVD process. Preferably, the chamber 2 is made of graphite.

In one or more preferred embodiments, such as the one illustrated, the apparatus 10 comprises a heating system for heating the reaction and deposition zone 100 to a predetermined temperature, normally within the range from 1000°C to 1700°C indicated above.

In one or more preferred embodiments, such as the one illustrated, the heating system is an induction heating system comprising at least one inductor 30, e.g. in the form of an electrical winding which surrounds the chamber 2 and extends along the reference axis Y. Preferably, between the inductor 30 and the chamber 2 are interposed different insulating and/or protective layers, which, however, are not illustrated in the

Figures 1 and 2 for the sake of simplicity of representation.

In one or more preferred embodiments, such as the one illustrated, the chamber 2 comprises a plurality of susceptors 21, 22, 23 and 24 assembled together and in reciprocal contact to form the chamber 2 itself.

In particular, with reference to figure 2, the susceptors 21, 22, 23 and 24 respectively comprise the walls 2D, 2E, 2F, and 2G delimiting the inner flow passage 2C.

In one or more preferred embodiments, such as the one illustrated, the susceptors 21 and 22 each have a hollow cylindrical configuration extending parallel to the reference axis Y.

In particular, in one or more preferred embodiments, such as the one illustrated, the susceptor 21 comprises a curvilinear wall 21A and the upper wall 2D connecting the opposite lateral ends of the curvilinear wall 21A to form a hollow cylindrical body having a half-moon shape.

Similarly, the susceptor 22 comprises a curvilinear wall 22A and the lower wall 2E connecting the opposite lateral ends of the curvilinear wall 22A to form a half-moon shaped hollow cylindrical body like the one of the susceptor 21, but in an upside-down arrangement with respect to the latter.

As already known per sé, when the inductor 30 is supplied with alternating current, electric currents are induced in the susceptors 21, 22, 23, and 24 and determine heating of the chamber 2 so as heat up the reaction and deposition zone 100 to the predetermined temperature.

The person skilled in the art will understand that the hollow cylindrical configuration of the two susceptors 21, 22 has the principal aim of making the induced electric currents follow the closed shape of the same susceptors.

On the other hand, it can be noted that the other susceptors 23 and 24 may instead, eventually, be replaced by electrical insulators.

In one or more preferred embodiments, the chamber 2 is constructed according to the teachings of the European patent n. EP3880863B1 to provide a given temperature profile within the chamber.

The alternative embodiment illustrated in figure 2A differs from the one of figures 1 and 2 in that the two susceptors 21, 22 have opposite, open, ends and in that two disks 25A, 25B, made of electrically insulating material, are coupled to these open ends to close, from opposite sides, the respective inner cavities 21C, 22C of the two susceptors 21, 22. Respectively made on the two disks 25A, 25B are the inlet 2A and the outlet 2B, which both communicate with the inner flow passage 2C.

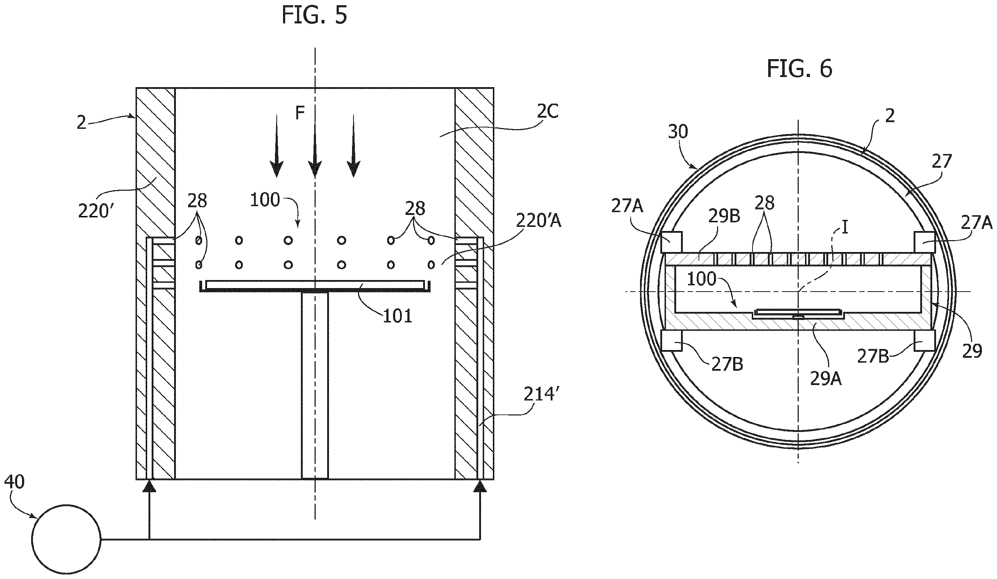

To the contrary, in the further alternative embodiment illustrated in figure 6, the chamber 2 comprises an outer susceptor 27 and an inner casing 29 containing the inner flow passage 2C and arranged in a condition of heat-exchange with the outer susceptor 27. The outer susceptor 27 circumferentially extends about a reference axis I to completely surround the inner casing 29.

In operation, the outer susceptor 27 is inductively heated by inductor 30, while the inner casing 29 is indirectly heated through the outer susceptor 27; preferably, the chamber 2 is configured so that heat transfer is realized from the outer susceptor 27 to the inner casing 29 via heat radiation.

In one or more preferred embodiments, such as the one illustrated, the inner casing 29 can be extracted from the outer susceptor 27 according to a translational movement along a direction parallel to the reference axis I, for executing preventive maintenance of the inner casing 29.

On this respect, it can be noted that in the prior art preventive maintenance usually includes disassembling the process chamber for enabling the operator to reach the inner flow passage 2C and the reaction and deposition zone 100; this of course entails long downtimes of the apparatus.

To the contrary, in this embodiment of the apparatus, the inner case 29 can be simply extracted from the outer susceptor 27, whenever preventive maintenance is due, so that no disassembling of the chamber 2 is to be performed.

Preferably, the inner casing 29 is slidably mounted inside the outer susceptor 27 by means of longitudinal guides 27A, 27B attached to the inner side of the susceptor 29 and running along the reference axis I; in the illustrated example, the susceptor 27 is provided with a pair of upper guides 27A engaging an upper side of the inner casing 29, and a pair of lower guides 27B engaging a lower side of the inner casing 29.

A robot arm provided with end-effector may be used for moving the inner casing 29 along the guides 27A, 27B to extract it from the susceptor 27.

In one or more preferred embodiments, such as the one illustrated, the inner casing 29 comprises a base 29A containing the receiving area 2H, preferably in the form of a generic drawer (i.e. a container having a bottom and lateral walls surrounding the bottom), and a cover 29B which is removably attached to the base 29A so that it can be separated from the latter during preventive maintenance, thus facilitating cleaning of the inside surfaces of the inner case 29. In their reciprocal assembled condition, the base 29A and the cover 29 together delimit the inner flow passage 2C.

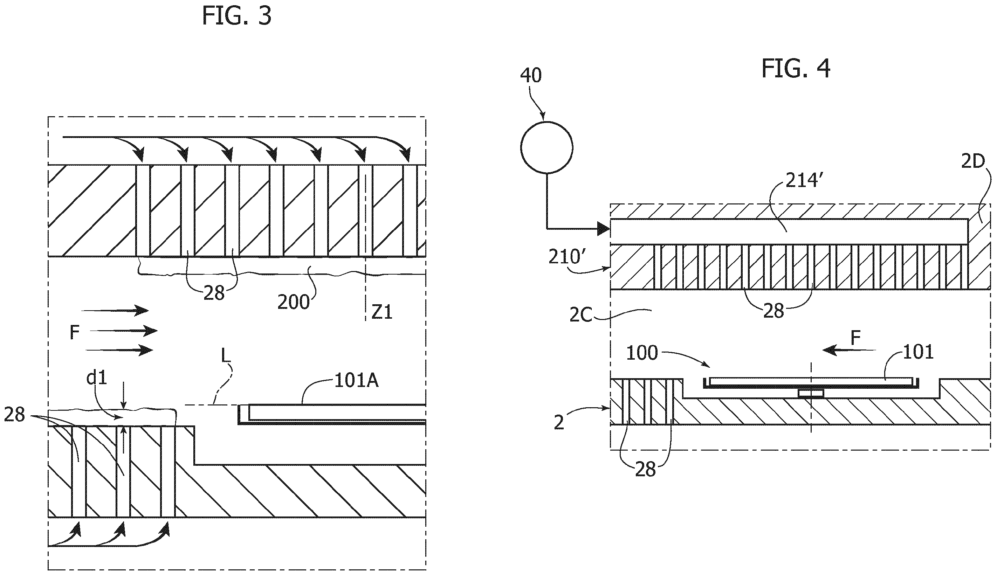

According to an important feature, the apparatus 10 comprises a gas source 40 for supplying an inert gas. Moreover, at least a wall of the chamber 2 delimiting the reaction and deposition zone 100 comprises a plurality of openings 28 which are in fluid communication with the gas source 40 and are configured to introduce the inert gas into the reaction and deposition zone 100 to form a gas layer 200 separating at least a portion of the wall of the chamber from a contact by the flow of process gas F (see Figure 3).

The inert gas may be a noble gas such as for example helium (He), neon (Ne), argon (Ar), krypton (Kr), or xenon (Xe). Preferably, the noble gas may be argon gas. Generally speaking, the inert gas may be any gas that does not react during the CVD process and that does not even interfere with the CVD process in any possible way; in particular, the inert gas does not contain silicon and carbon. The inert gas may be provided in a pressurized tank of the supply unit 40.

Preferably, the plurality of openings 28 are in the form of a two-dimensional array of openings 28 covering a predetermined area of the wall.

The openings 28 can have a cross-section of various shapes, e.g. circular, elliptical, slit-shaped, etc., depending on the needs and/or the circumstances of the specific applications.

Moreover, the openings 28 may have their longitudinal axes Z1 orthogonal to the wall of the chamber 2 or inclined with respect to it. In this second case, the longitudinal axes of the openings 28 are preferably inclined towards the outlet 2B of the chamber 2 (with respect to a point of observation outside of the chamber), so that the velocity of the flow of inert gas exiting from the openings 28 has a component directed towards the outlet 2B itself.

In one or more preferred embodiments, such as the one illustrated, the openings 28 are made in the upper wall 2D and, preferably, to cover an area A1 of the same wall extending over the receiving area 2H and also upstream of the receiving area with respect to the direction of the flow of process gas F.

In one or more preferred embodiments, such as the one illustrated, openings 28 are also made in the lower wall 2E and, preferably, to cover an area A2 of the same wall upstream of the receiving area 2H with respect to the direction of the flow of process gas F.

In an alternative embodiment (not shown), the at least a wall of the chamber 2 comprises instead a single elongated opening that is, by itself, configured to introduce the inert gas into the reaction and deposition zone 100 to form the gas layer 200.

Preferably, the elongated opening is in the form of a slit and extends along a direction transversal to the direction of the flow of process gas F and is configured to introduce into the reaction and deposition zone 100 a gas veil- which represents the protective gas layer 200 above discussed - immediately adjacent to the chamber's wall and covering the latter from the flow of process gas F.

Preferably, the areas A1 and/or A2 have a width W - measured along a direction transversal to the reference axis Y - at least equal to the width of the receiving area 2H.

Referring to the elongated opening above indicated, preferably it has a length equal to at least 50% of the dimension of the receiving area 2H in the direction transversal to the direction of the gas flow F.

Considering now the technical problem of the parasitic deposition of particles discussed at the beginning, the gas layer 200 constitutes a separation layer preventing particles generated by CVD and contained in the flow of process gas F - or at least a relevant portion of these particles - from adhering to the at least a wall of the chamber 2, e.g. the upper wall 2D and / or the lower wall 2E.

In this way, the accumulation of particles in the chamber is eliminated or at least its respective accumulation rate is substantially reduced.

The gas layer 200 is formed and maintained as such by the inert gas that is constantly introduced into the chamber 2 via the openings 28. This gas flows on the wall and ends to be finally evacuated via the outlet 2B together with the process exhaust gas.

The person skilled in the art will understand that size, shape, reciprocal distance, orientation, total number, etc. of the openings 28 may be selected based on the features (such as area, thickness, density) of the gas layer to be formed. These data may be obtained experimentally for any specific application of the apparatus described here. The same applies for operation parameters such as pressure and flow rate of the inert gas.

In one or more preferred embodiments, such as the one illustrated, the gas layer 200 formed on the lower wall 2E has a thickness d1 that is smaller than the distance of the lying plane L from the same wall, so that the upper surface 101A of the substrate 101, lying in the same plane L, finds itself completely above the gas layer 200, and thus any eventuality that the gas layer 200 may affect the film deposition on the substrate 101 is eliminated.

Preferably, the openings 28 are the result of machining the wall by removal of material or of the production of the wall by a forming process.

For example, the openings 28 can be made by drilling.

In an alternative embodiment, the wall (and the chamber component it is part of) is realized by casting and the casting mold has inner formations configured to realize the plurality of openings 28 directly in the casting material, e.g. graphite.

In one or more preferred embodiments, such as the one illustrated, the susceptor 21 is configured to set its respective openings 28 in fluid communication with the gas source 40 via the inner cavity 21C, so that the latter finds itself to constitute a flow passage for delivering the inert gas to the openings 28. For example, in one or more preferred embodiments, such as the one illustrated in figure 2, the susceptor 21 has an inlet 21D opening into the inner cavity 21C and connected to the gas source 40; in the embodiment of figure 2A analogous openings 21D', 21C' are conversely made in disk 25A.

Similarly, in one or more preferred embodiments, such as the one illustrated, the susceptor 22 is configured to set its openings 28 in fluid communication with the gas source 40 via the inner cavity 22C; for example, in one or more preferred embodiments, such as the one illustrated, the susceptor 22 has an inlet 22D opening into the inner cavity 22C and connected to the gas source 40.

In view of the above, it will be appreciated how the preferred embodiment discussed above is able to exploit the inner cavity commonly present in a susceptor like the susceptors 21 and 22 to connect the openings 28 of the susceptors to the gas source 40 and, thus, to solve the problem of delivering the gas to these openings in a very simple and reliable manner.

Referring now to the alternative embodiment of Figure 6, the openings 28 are made in the cover 29B of the inner casing 29.

Moreover, similarly to what has been described above with reference to the susceptors 21, 22, the outer susceptor 27 is in fluid communication with the gas source 40 and is configured to deliver the inert gas to the openings 28 made in the cover 29B, through its inner cavity 27C, particularly the portion thereof that is defined between the inner side of the outer susceptor 27 and the cover 29B of the inner casing 29.

In a further embodiment, the openings 28 may also be made in the bottom wall of base 29A which defines the receiving area 2H.

Figures 4 and 5 show further embodiments of the apparatus here described.

In the following, the same reference numbers of the preceding embodiment are used to refer to the same or like parts.

Figure 4 shows a process chamber 2 comprising an inner case 210' to delimit the reaction and deposition zone 100.

The process gas may be supplied to the case 210' via an inlet (not shown) provided at one end of the case or at the same region of the case where is also located the reaction and deposition zone 100.

In any case, the flow of process gas F across the case 210' is parallel to the lying plane L of the substrate 101.

The case 210' comprises the upper wall 2D of the flow passage 2C, provided with the openings 28, but it has no inner cavity confining with the wall 2D for delivering the inert gas to the openings 28. Instead, according to this embodiment, the delivering of the inert gas to the openings 28 is accomplished via an inner passage 214' directly made in the wall 2D.

For the realization of the inner passage 214' in the wall, the same teachings apply that are provided above with reference to the realization of the openings 28.

On the other hand, figure 5 shows a chamber 2 having a wall 220' that extends according to a cylindrical shape about an axis Z and delimits the reaction and deposition zone 100 in such a way that the lying plane L of the substrate 101 is orthogonal to the axis Z of the same wall. Correspondingly, the flow of process gas F is orthogonal to the lying plane L.

The wall 220' comprises the plurality of openings 28, which are preferably arranged to cover an entire cylindrical portion 220'A of the wall 220' surrounding the supporting element 102.

The gas layer 200 formed by the inert gas introduced via such an array of openings 28 has a corresponding ring configuration.

Analogously to the previous embodiment, the delivering of the inert gas to the openings 28 is accomplished via an inner passage 214' (or a plurality of inner passages) directly made in the wall 220' itself. The inner passage 214' can be made according to the same teachings provided above with reference to the realization of the openings 28.

Like in the preferred embodiment, in both the further embodiments of Figure 4 and 5 the inert gas introduced into the reaction and deposition zone 100 via the openings 28 - made in the upper wall 2D of the case 210', in the embodiment of figure 4, or in the wall 220', in the embodiment of figure 5 - forms a gas layer 200 separating the wall of the chamber from a contact by the flow of process gas F.

In one or more preferred embodiments, the apparatus here described may also comprise a third gas source (not illustrated) for supplying a cleaning gas.

The cleaning gas may be any gas suitable to remove particles from the at least one opening 28 and from the at least a wall 2D of the chamber 2, such as Cl₂, ClF₃, NF₃, O₂, HCl and/or combinations thereof, such as Cl₂ + 02.

The above examples are suitable to etch silicon carbide deposits, especially at temperatures above 500°C, preferably above 800°C.

The cleaning gas can be selectively set in fluid communication with the at least one opening 28 to introduce the cleaning gas into the reaction and deposition zone 100 to remove particles from the at least one opening 28 and from the at least a wall 2D of the chamber 2. In this way, particles that, despite the separation provided by the gas layer 200, could eventually deposit on the at least a wall 2D of the chamber 2 can be removed and thus any intervention of maintenance on the chamber can be postponed.

In one or more preferred embodiments, the apparatus here described may also comprise a fourth gas source (not illustrated) for supplying an etching gas, e.g. hydrogen, for performing etching of SiC parasitic films that have been generated in the chamber 2 as byproducts of the CVD epitaxial reaction.

In view of the above, the apparatus here described can prevent parasitic particulates generated as by-product of a CVD epitaxial reaction, from adhering on one or more walls of the reaction chamber.

Preferably, a process comprising the following steps can be implemented in the described apparatus, for preventing adherence of such parasitic particulates on the at least one wall of the apparatus comprising the at least one opening 28:
(i) ramping the chamber 2 to a process temperature of 1000°C - 1700°C, preferably of 1500°C - 1650°C;
(ii) maintaining the process temperature of the chamber 2 constant;
(iii) flowing the process gas F to the reaction and deposition zone 100 through the flow passage 2C; and
(iv) flowing an inert gas into the reaction and deposition zone 100 through the at least one opening 28, thereby forming a gas layer 200 separating at least a portion of the at least one wall (2D, 2E; 220') from a contact by the flow of process gas F;
(v) cooling the chamber 2 to a temperature ≤ 900°C; wherein steps (iii) and (iv) are performed simultaneously during step (ii), and the process gas F comprises at least a first gas chosen from a chlorinated compound, preferably dichlorosilane, trichlorosilane or tetrachlorosilane, and at least a second gas chosen from hydrocarbons, preferably propane or ethylene or acetylene or methane.

Preferably, the above-indicated process further comprises a step (i') of flowing a cleaning gas into the reaction and deposition zone 100 through the at least one opening 28, wherein the cleaning gas comprises Cl₂, ClF₃, NF₃, O₂, and/or HCl and step (i') is executed before step (iii) or after step (iv); preferably, step (i') is executed when the chamber 2 is at a temperature above 500 °C, even more preferably above 800 °C.

Preferably, the above-indicated process further comprises a step (ii') of flowing hydrogen to the reaction and deposition zone (100) through the flow passage (2C), wherein step (ii') is executed during step (ii) and before steps (iii) and (iv); step (ii') may be executed contemporarily to step (i') provided that the cleaning gas is not Oxygen.

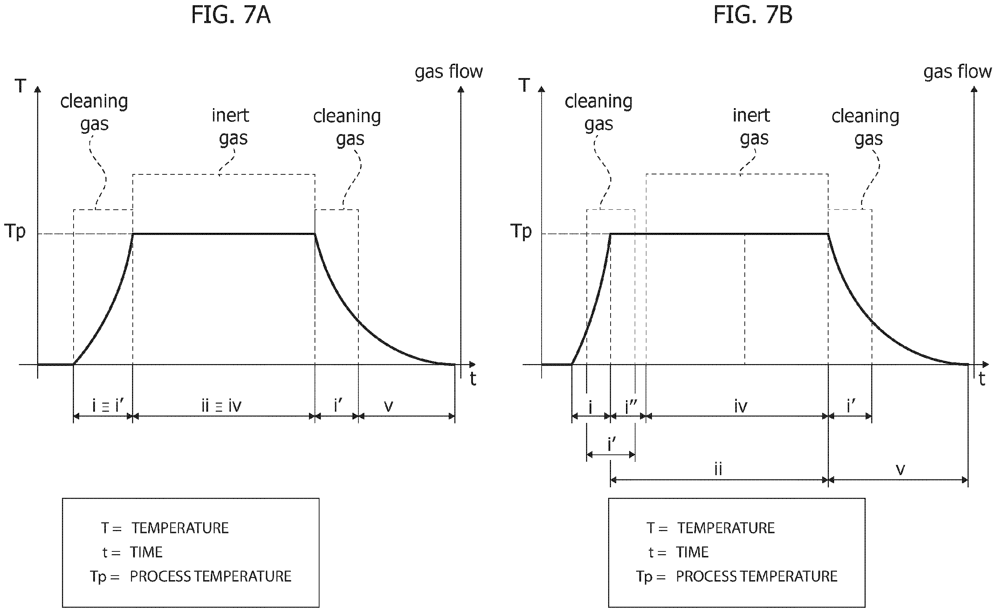

With reference now to Figures 7A and 7B, each illustrates a diagram representing the curve of the chamber's temperature over time as well as the curves of the flow rate respectively of the inert gas and of the cleaning gas through the openings 28, during the above indicated process; along the time line there are indicated steps i), i'), ii), ii'), iv) and v) of the same process.

It can be noted that the diagram of Figure 7A refers to an embodiment of the process in which the time interval of step i') coincides with the time interval of step i), and, analogously, the time interval of step iv) coincides with the time interval of step ii); this means that cleaning is effected during the heating of the chamber 2 to the process temperature and thereafter the CVD process immediately starts, together with the flowing of the inert gas into the reaction and deposition zone 100 for protecting the chamber's wall from the process gas.

To the contrary, the diagram of Figure 7B refers to a process in which, when the chamber has reached the process temperature, cleaning is still performed for some time, and, thereafter, before the CVD process is started, always accompanied by the flowing of the inert gas, etching of SiC parasitic films is performed by flowing hydrogen to the reaction and deposition zone 100 according to step ii'.

The apparatus here described can be purposely configured to implement the process above described. For example, the apparatus may comprise a control unit configured to control the heating system and the gas sources of the apparatus so as to implement the process in question.

Clearly, provided that the principle of the invention is retained, the details of construction and forms of embodiment can be varied, even to a significant degree, from what has been illustrated herein purely by way of non-limiting example, without thereby departing from the scope of the invention, as defined in the attached claims.

## Claims

1. Apparatus for manufacturing semiconductor devices of the type comprising a substrate (101) and a film applied onto the substrate by means of a chemical-vapor-deposition (CVD) process, comprising:
- a chamber (2) containing a reaction and deposition zone (100) in which to arrange at least one substrate (101), and comprising at least a wall (2D, 2E; 220') delimiting the reaction and deposition zone (100);
- a first gas source (20) for supplying a flow of process gas (F) into the reaction and deposition zone (100) in a first direction;
- a second gas source (40) for supplying a gas into the reaction and deposition zone (100) in a second direction;
wherein the at least a wall (2D, 2E; 220') of the chamber (2) comprises at least one opening (28) on the reaction and deposition zone (100), which is in fluid communication with the second gas source (40) and is configured to introduce the inert gas into the reaction and deposition zone (100) to form a gas layer (200) separating at least a portion of the at least a wall (2D, 2E; 220') from a contact by the flow of process gas (F) .

2. Apparatus according to claim 1, wherein the at least a wall (2D, 2E; 220') of the chamber (2) comprises a plurality of openings (28) that are configured to introduce the inert gas into the reaction and deposition zone (100) to form the gas layer (200), said plurality of openings being preferably arranged according to a two-dimensional array of openings (28) covering a predetermined area (A1, A2; 220'A) of the wall.

3. Apparatus according claim 1 or 2, wherein the reaction and deposition zone (100) comprises a receiving area (2H) which is configured to receive the substrate (101) according to a given lying plane (L), and wherein the at least a wall (2D) of the chamber comprising the at least one opening (28) is opposed to the receiving area (2H) and substantially parallel to the lying plane (L) .

4. Apparatus according to claim 3, wherein the chamber (2) comprises a second wall (2E) which is provided with the receiving area (2H) that is to receive the substrate (101), and wherein the second wall (2E) comprises at least one opening (28) on an inner zone of the chamber (2) that is upstream of the reaction and deposition zone (100) with respect to the flow direction of the flow of process gas (F), said at least one opening (28) being in fluid communication with the second gas source (40) and configured to introduce the inert gas into the upstream zone to form a gas layer (200) separating at least a portion of the second wall (2E) from the flow of process gas.

5. Apparatus according to claim 4, wherein the at least a wall (2D) and/or the second wall (2E) comprise at least one opening (28) on an inner zone of the chamber (2) that is downstream of the reaction and deposition zone (100) with respect to the flow direction of the flow of process gas (F), said at least one opening (28) being in fluid communication with the second gas source (40) and configured to introduce the inert gas into the downstream zone to form a gas layer (200) separating at least a portion of the at least a wall (2D) or of the second wall (2E) from the flow of a process exhaust gas exiting the chamber (2).

6. Apparatus according to any one of the preceding claims,
wherein the chamber (2) comprises at least one susceptor electromagnetically coupled to an inductor and configured to heat the reaction and deposition zone (100) to a predetermined temperature;
wherein the susceptor has an inner cavity (21C, 22C) which is set in fluid communication with the second gas source (40) and is configured to deliver the inert gas to the at least one opening (28).

7. Apparatus according to claim 6, wherein the chamber (2) comprises a plurality of susceptors (21, 22; 21, 22, 23, 24) assembled together to delimit a flow passage (2C) containing the reaction and deposition zone (100) and set in fluid communication with the first gas source (20), and
wherein at least one of the susceptors (21, 22) has an inner cavity (21C, 22C) which is set in fluid communication with the second gas source (40), and has the at least a wall (2D, 2E) which is interposed between the flow passage (2C) and the inner cavity (21C, 22C) of the susceptor (21, 22), the holes (28) of the at least a wall setting the inner cavity (21C, 22C) and the flow passage (2C) into reciprocal fluid communication.

8. Apparatus according to claim 7, wherein the chamber (2) comprises a pair of susceptors (21, 22) and a pair of electrical insulators, which are assembled together and are in reciprocal contact to delimit the flow passage (2C) and form the chamber (2).

9. Apparatus according to any one of the preceding claims, wherein the at least one opening (28) is an elongated opening configured to introduce the inert gas into the reaction and deposition zone (100) to form the gas layer (200), wherein the elongated opening is a slit on the a wall (2D) of the chamber (2) extending along a direction transversal to the direction of the gas flow in the reaction and deposition zone, for a length equal to at least 50% of dimension of the receiving area in the same transversal direction.

10. Apparatus according to any one of the preceding claims, wherein the at least a wall (2D, 220') comprising the at least one opening (28) has an inner passage (214') which fluidly connects the at least one opening (28) to the second gas source (40).

11. Apparatus according to any one of the preceding claims, wherein the reaction and deposition zone (100) comprises a receiving area (2H) which is configured to receive the substrate (100) according to a given lying plane (L), and wherein the at least a wall (220') of the chamber extends according to a cylindrical shape about an axis (Z) orthogonal to the lying plane (L).

12. Apparatus according to any one of the preceding claims, comprising a third gas source for supplying a cleaning gas, which can be selectively set in fluid communication with the at least one opening (28) to introduce the cleaning gas into the reaction and deposition zone (100) to remove particles from the at least one opening (28) and from the at least a wall (2D) of the chamber (2).

13. Method for manufacturing semiconductor devices of the type comprising a substrate (101) and a film applied onto the substrate by means of a chemical-vapor-deposition (CVD) process, comprising:
- arranging at least one substrate (101) in a reaction and deposition zone (100) contained in a chamber (2) and delimited by at least a wall (2D, 2E; 220') of the chamber (2);
- supplying a flow of process gas to the reaction and deposition zone (100) of the chamber (2);
- introducing an inert gas into the reaction and deposition zone (100) via at least one opening (28) provided in the at least a wall of the chamber to form a gas layer (200) separating at least a portion of the at least a wall from the flow of process gas.

14. Method according to claim 13, comprising:
- introducing a cleaning gas into the reaction and deposition zone (100) via the at least one opening (28) to remove particles from the at least one opening (28) and the at least a wall (2D) of the chamber (2).

15. A process for preventing SiC parasitic particulates generated as by-product of a CVD epitaxial reaction, from adhering on the at least a wall of the reaction chamber of the apparatus according to any one of claims 1-12, wherein the process comprises the steps of:
(i) ramping the chamber (2) to a process temperature of 1000°C - 1700°C, preferably of 1500°C - 1650°C;
(ii) maintaining the process temperature of the chamber (2) constant;
(iii) flowing the process gas (F) to the reaction and deposition zone (100) through the flow passage (2C); and
(iv) flowing an inert gas into the reaction and deposition zone (100) through the at least one opening (28), thereby forming a gas layer (200) separating at least a portion of the at least a wall (2D, 2E; 220') from a contact by the flow of process gas (F);
(v) cooling the reaction chamber to a temperature <_ 900°C;
wherein steps (iii) and (iv) are performed simultaneously during step (ii), and the process gas (F) comprises at least a first gas chosen from a chlorinated compound, preferably dichlorosilane, trichlorosilane or tetrachlorosilane, and at least a second gas chosen from hydrocarbons, preferably propane or ethylene or acetylene or methane.

16. The process according to claim 15, further comprising the step (i') of flowing a cleaning gas into the reaction and deposition zone (100) through the at least one opening (28), wherein the cleaning gas comprises Cl₂, ClF₃, NF₃, O₂, and/or HCl and step (i') is executed before step (iii) or after step (iv), preferably at a temperature above 500 °C, even more preferably above 800 °C.

17. The process according to claim 15 or 16, further comprising the step (ii') of flowing hydrogen into the reaction and deposition zone (100) through the flow passage (2C); wherein step (ii') is executed during step (ii) and before step (iii) and (iv), and wherein step (ii') is eventually executed contemporarily to step (i') if the cleaning gas is not Oxygen.
